# EUROPEAN PATENT APPLICATION

(11) **EP 4 682 879 A1**
(43) Date of publication of application: **21.01.2026**
(21) Application number: 24188734.8
(22) Date of filing: 16.07.2024
(51) Int. Cl.: G10L 25/51, G01R 31/28

(54) **METHOD AND DEVICE FOR IDENTIFYING A COMPONENT OF AN ELECTRONIC MODULE**

(71) Applicant: Bayerische Motoren Werke Aktiengesellschaft, 80809 München (DE)
(72) Inventor: Greuet, Jean-Baptiste, 85635 Höhenkirchen (DE); Iosava, Sofia, 80636 München (DE); Boensch, Bastian, 83670 Bad Heilbrunn (DE)

(57) **Abstract**

The present document describes a device for identifying a component of an electronic module. The device comprises a sensor element which is configured to provide a measurement signal that is dependent on electromagnetic emission of the electronic module, which is emitted during operation of the electronic module, wherein the measurement signal exhibits a signal frequency range which differs from an emission frequency range of the electromagnetic emission. Furthermore, the device comprises a processing unit which is configured to identify at least one component of the electronic module based on the measurement signal.

## Description

The present document is directed at identifying a component of an electronic module, e.g., an electronic module of a vehicle, based on an electromagnetic noise, e.g. EM emission, pattern.

A vehicle, notably a battery electric vehicle, comprises one or more electronic modules which produce electromagnetic emission (e.g. radiated emission and/or conducted emission) during operation of the vehicle. The electromagnetic emission of an electronic module may be subjected to legal requirements, notable with respect to the maximum allowed intensity of the electromagnetic emission.

The present document is directed at the technical problem of identifying one or more different components of an electronic module, in an efficient and reliable manner, e.g., in order to detect a component causing electromagnetic emission at a certain level. The technical problem is solved by the independent claims. Preferred examples are specified in the dependent claims.

According to an aspect, a device for identifying a component of an electronic module is described. The module may be part of a vehicle. Example components are: a power converter, a power switch, an ISDN component, an Ethernet component, an SPI (Serial Peripheral Interface) component, an I2C (Inter-integrated circuit) component, a Flyback transformer, a MOSFET, a IGBT, a SiC (Silicon Carbide) power module, etc.

The device comprises a sensor element which is configured to provide a measurement signal that is dependent on the electromagnetic emission of the electronic module, wherein the electromagnetic emission is produced during operation of the electronic module (notably as radiated and/or conducted emission). The measurement signal may be provided such that the measurement signal exhibits a signal frequency range which differs from the emission frequency range of the electromagnetic emission. Hence, the signal frequency range may comprise different frequencies than the emission frequency range. In particular, the signal frequency range and the emission frequency range may be disjoint from one another.

The maximum frequency of the signal frequency range may be lower than the minimum frequency and/or the maximum frequency of the emission frequency range. In particular, the maximum frequency of the signal frequency range may be 30 kHz or less (notably 20 kHz or less), and/or the minimum frequency and/or the maximum frequency of the emission frequency range may be 100kHz or more, notably 1MHz or more. In a preferred example, the signal frequency range of the measurement signal comprises and/or corresponds to the audio frequency range (such that the measurement signal is audible for a human being, when the measurement signal is rendered by a loudspeaker).

The sensor element may be configured to demodulate the electromagnetic emission from the emission frequency range to the signal frequency range, to provide the measurement signal. In a preferred example, the sensor element comprises, notably is, a hearing aid coil (HAC).

Furthermore, the device comprises a processing unit which is configured to identify at least one component of the electronic module based on the measurement signal.

The processing unit may be configured to determine and/or to create a spectrogram of the measurement signal (wherein the spectrogram may comprise the dimensions: frequency, amplitude and/or time). The spectrogram may be determined by applying a time-domain to frequency-domain transform, such as a Fast Fourier Transform, to the measurement signal. In other words, a time-domain to frequency-domain transform, such as a Fast Fourier Transform, of the measurement signal may be calculated, in order to determine the spectrogram. The spectrogram may be displayed.

Furthermore, the processing unit may be configured to analyze the spectrogram of the measurement signal. In particular, the processing unit may be configured to identify the at least one component of the electronic module based on the spectrogram of the measurement signal. In this context, the processing unit may be configured to compare the spectrogram of the measurement signal with a plurality of different reference spectrograms for a corresponding plurality of reference components (wherein the plurality of different reference spectrograms may be provided within a database). Furthermore, the device may be configured to identify the at least one component of the electronic module, notably to identify the at least one component of the electronic module as being one of the plurality of reference components, based on the comparison

In a preferred example, the processing unit is configured to make use of a pattern recognition algorithm, notably an artificial intelligence-based pattern recognition algorithm, to identify the at least one component of the electronic module based on the measurement signal, notably based on the spectrogram of the measurement signal.

By making use of a measurement signal in a signal frequency range which is transposed with respect to the emission frequency range of the electromagnetic emission of the electronic device, a particularly efficient and precise identification of one or more components of the electronic module may be achieved.

According to a further aspect, a method for identifying a component of an electronic module is described. The method comprises capturing a measurement signal that is dependent on the electromagnetic emission of the electronic module, which is emitted during operation of the electronic module. The measurement signal may be captured such that the measurement signal exhibits a signal frequency range which differs from the emission frequency range of the electromagnetic emission. Furthermore, the method comprises identifying at least one component of the electronic module based on the measurement signal.

It should be noted that the methods and systems including its preferred embodiments as outlined in the present patent application may be used stand-alone or in combination with the other methods and systems disclosed in this document. Furthermore, all aspects of the methods and systems outlined in the present patent application may be arbitrarily combined. In particular, the features of the claims may be combined with one another in an arbitrary manner. Furthermore, it is noted that brackets are used within the present document to indicate optional features.

The invention is explained below in an exemplary manner with reference to the accompanying drawings, wherein
Fig. 1 shows an example device for identifying an electronic component of an electronic module;
Fig. 2 shows a flow chart of an example method for identifying an electronic component of an electronic module; and
Fig. 3 shows an example spectrogram of a measurement signal.

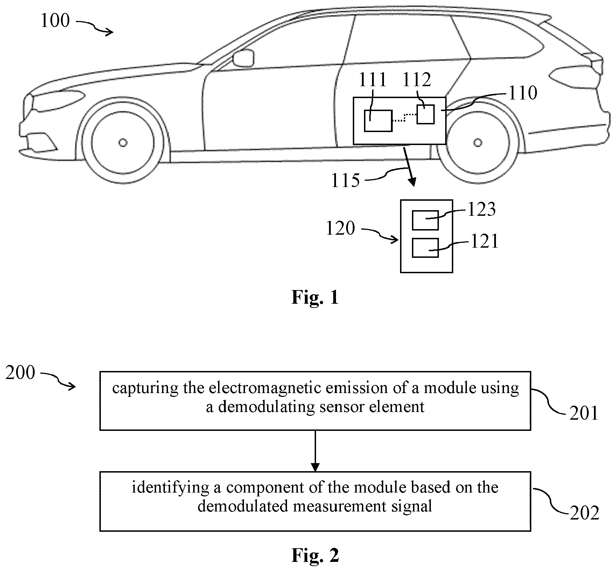

As outlined above, the present document is directed at identifying one or more electronic components of an electronic module in an efficient and reliable manner. In this context, Fig. 1 shows a vehicle 100 which comprises an electronic module 100, wherein the electronic module 110 comprises a first component 111 and a second component 112. An example module 110 is an inverter which is configured to generate a multi-phase alternating current for operating an electrical motor of the vehicle 100 based on a direct current which is provided by a battery of the vehicle 100. Example components 111, 112 of the electronic module 110 may be power switches, such as MOSFETs or IGBTs, and/or one or more other electronic components of a printed circuit board (PCB), e.g. of a vehicle 100 and/or of an inverter.

The electronic module 110 produces electromagnetic emission 115 (e.g., radiated emission and/or conducted emission) during operation of the module 110, wherein the electromagnetic emission 115 of the module 110 is typically a combination of the individual electromagnetic emission which is emitted by the different components 111, 112 of the module 110.

Fig. 1 shows an example analysis device 120 which comprises a sensor element 123 that is configured to capture the electromagnetic emission 115 of the electronic module 110. In particular, the sensor element 123 may be configured to provide a measurement signal, wherein the measurement signal is dependent on the electromagnetic emission 115. The sensor element 123 may comprise an antenna and/or a coil.

The electromagnetic emission 115 of an electronic module 110 exhibits a certain emission frequency range, wherein the emission frequency range is typically located in the MHz or GHz range. The processing of a measurement signal in such a high frequency range may be relatively complex. In view of this, a sensor element 123 may be used, which is configured to demodulate and/or transpose the captured electromagnetic emission 115 into a signal frequency range, wherein the maximum frequency of the signal frequency range is preferably lower than the maximum frequency of the emission frequency range. In a preferred example, the signal frequency range corresponds to the audio frequency range, e.g., with a maximum frequency of 30kHz or less, notably 20kHz or less.

Hence, the sensor element 123 may be configured to provide a measurement signal which is indicative of the electromagnetic emission 115, wherein the measurement signal has a signal frequency range that differs from the emission frequency range of the electromagnetic emission 115. In a preferred example, the measurement signal is an audio signal (that can be rendered by a loudspeaker and/or that can be listened to by a human being).

The measurement device 120 further comprises a processing unit 121 which is configured to process the measurement signal in order to identify one or more components 111, 112 of the electronic module 110. For this purpose, a frequency spectrum, notably a spectrogram, of the measurement signal may be determined, e.g. using a Fourier Transformation, in order to determine a pattern which represents the measurement signal. Hence, the spectrogram of the measurement signal may be used as a pattern that represents the measurements signal.

A pattern recognition algorithm may be used to identify one or more partial patterns within the pattern of the measurement signal, wherein the one or more partial patterns correspond to one or more different components 111, 112 of the electronic module 110.

As outlined above, the electromagnetic (EM) emission 115 (notably EM noise) which is emitted by electronic circuitry 110 (i.e., by an electronic module) during EMC (electromagnetic compatibility) measurements may have a typical pattern in time, frequency and/or amplitude. Similar to the recognition of music, a time-tracking of one or more characteristics of the EM emission 115 may be used to recognize precisely which element or component 111, 112 (for example an ICs, a Flyback transformer, a DCDC converter, etc.) causes which noise peak of the recorded emission 115. Similar to the recognition of music, a spectrogram of the emission 115, recorded by means of a coil or antenna 123, may be determined. If several sources are present in the measurement signal, an AI (Artificial Intelligence) and/or a pattern recognition algorithm may be used to recognize and distinguish the characteristics of different EMC sources 111, 112. In particular, a coil (notably a hearing aid coil for a hearing impairment device) may be used to pick up the EM emissions 115, wherein the coil may be configured to transfer the EM emissions 115 into an audio signal which may be rendered via a loudspeaker. The rendered sound may be analyzed via a sound analyzer and/or via a measurement receiver.

The emissions 115 of complex systems (i.e. of complex modules) 110 like the components of power electronics come from multiple noise sources, i.e. components 111, 112. As outlined, a spectrogram (notably a three-dimensional pattern (time, frequency, amplitude) of a measurement signal, e.g., recorded by a spectrum analyzer, a measurement receiver, or an oscilloscope and/or captured via a coil or an antenna 123, may be determined. The comparison of this spectrogram with a database of pre-recorded (reference) spectrograms, e.g., using an artificial intelligence (AI) and/or pattern recognition algorithm, may be used to identify the one or more EM sources 111, 112 which are present in the system 110.

When using an unfiltered hearing aid coil (HAC) as a sensor element 123 in order to pick up the electronic noise from the system 110, the demodulated HAC coil measurement signal may be listened to on a loudspeaker (additionally, or alternatively to a spectrogram analysis) to determine the origin and the characteristic of the one or more noise sources 111, 112. One or more different sound patterns may be recognized and analyzed by a human expert, in order to identify the one or more different noise sources 111, 112.

In an example setup, a HAC coil 123 may be connected to a loudspeaker or an audio analyzer. The measurement signal is picked up and an AI database (or a human expert) may be used to recognize the pattern of the measurement signal, allowing to recognize one or more different noise sources 111, 112 (e.g., a DCDC converter, an ISDN component, an Ethernet component, an SPI component, an I2C component, a Flyback transformer, a MOSFET, a IGBT, a SiC power module, etc.).

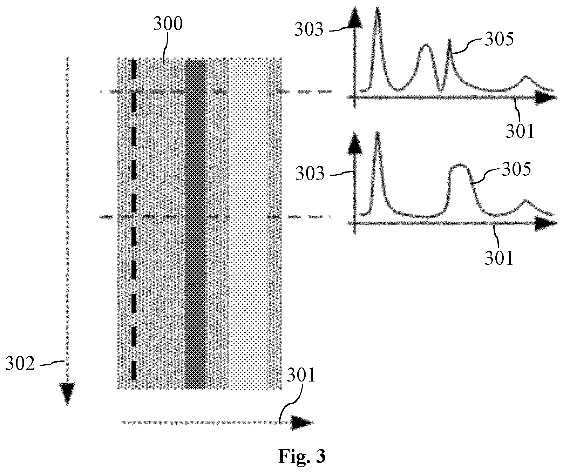

Fig. 3 shows an example spectrogram 300 which may be determined based on the measurement signal, e.g. by applying a Fast Fourier Transform to the measurement signal. The spectrogram 300 may indicate the intensity 303 of the captured EM emission 115 as a function of frequency 301 and time 302. Fig. 3 shows individual spectra 315 from the spectrogram 300 for different time instants.

The module spectrogram 300 of an electronic module 110 is typically the overlay of a plurality of component spectrograms 300 of the corresponding plurality of components 111, 112 comprised within the electronic module 110. An (artificial intelligence based) pattern recognition algorithm may be used to identify the set of (one or more) component spectrograms 300 which are comprised within the module spectrogram 300 of the electronic module 110. Based on the identified set of component spectrograms 300, the corresponding set of (one or more) components 111, 112, which are comprised within the module 110 may be determined.

Fig. 2 shows a flow chart of an example method (200) for identifying a component 111, 112 of an electronic module 110. The method 200 comprises capturing 201 a measurement signal that is dependent on electromagnetic emission 115 of the electronic module 110, wherein the electromagnetic emission 115 is emitted during operation of the electronic module 110. The measurement signal may be captured using a sensor element 123. The measurement signal may be captured such that the measurement signal exhibits a signal frequency range which differs from the emission frequency range of the electromagnetic emission 115. This may be achieved by making use of a sensor element 123 which has an inherent demodulation capacity, such as a hearing aid coil (HAC). In a preferred example, the signal frequency range is or comprises the audio frequency range.

Furthermore, the method 200 comprises identifying at least one component 111, 112 of the electronic module 110 based on the measurement signal. For this purpose, a (three-dimensional) spectrogram 300 of the measurement signal may be determined. The dimensions of the spectrogram 300 may be amplitude 303, frequency 301 and/or time 302. The spectrogram 300 of the measurement signal may be analyzed, e.g., using a pattern recognition algorithm, in order to identify at least one component 111, 112 of the electronic module 110.

The spectrogram 300 of the measurement signal may be referred as the module spectrogram 300 (for the entire module 110). The module spectrogram 300 may comprise a set of one or more component spectrograms 300 for a corresponding set of one or more components 111, 112. A pattern algorithm may be used to identify the one or more component spectrograms 300 which make up the module spectrogram 300. The one or more identified component spectrograms 300 indicate the one or more components 111, 112 which are comprised within the module 110.

By providing a measurement signal of the electromagnetic emission 115 of an electronic module 110, which exhibits a demodulated signal frequency range, the one or more different components 111, 112 of the module 110 may be identified in an efficient and precise manner.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A device (120) for identifying a component (111, 112) of an electronic module (110); wherein the device (120) comprises
- a sensor element (123) which is configured to provide a measurement signal that is dependent on electromagnetic emission (115) of the electronic module (110), which is emitted during operation of the electronic module (110); wherein the measurement signal exhibits a signal frequency range which differs from an emission frequency range of the electromagnetic emission (115); and
- a processing unit (121) which is configured to identify at least one component (111, 112) of the electronic module (110) based on the measurement signal.

2. The device (120) of claims 1, wherein
- a maximum frequency of the signal frequency range is lower than a minimum frequency and/or a maximum frequency of the emission frequency range; and/or
- the emission frequency range and the signal frequency range are disjoint from one another.

3. The device (120) of any previous claims, wherein
- a maximum frequency of the signal frequency range is 30 kHz or less; and/or
- a minimum frequency and/or maximum frequency of the emission frequency range is 100kHz or more, notably 1MHz or more.

4. The device (120) of any previous claims, wherein the signal frequency range of the measurement signal comprises and/or corresponds to an audio frequency range.

5. The device (120) of any previous claims, wherein the sensor element (123) is configured to demodulate the electromagnetic emission (115) from the emission frequency range to the signal frequency range, to provide the measurement signal.

6. The device (120) of any previous claims, wherein the sensor element (123) comprises a hearing aid coil.

7. The device (120) of any previous claims, wherein the processing unit (121) is configured to
- determine a spectrogram of the measurement signal; and
- identify the at least one component (111, 112) of the electronic module (110) based on the spectrogram of the measurement signal.

8. The device (120) of claim 7, wherein the processing unit (121) is configured to
- compare the spectrogram of the measurement signal with a plurality of different reference spectrograms for a corresponding plurality of reference components; and
- identify the at least one component (111, 112) of the electronic module (110), notably to identify the at least one component (111, 112) of the electronic module (110) as being at least one of the plurality of reference components, based on the comparison

9. The device (120) of any of the previous claims, wherein the processing unit (121) is configured to make use of a pattern recognition algorithm, notably an artificial intelligence-based pattern recognition algorithm, to identify the at least one component (111, 112) of the electronic module (110) based on the measurement signal, notably based on a spectrogram of the measurement signal.

10. A method (200) for identifying a component (111, 112) of an electronic module (110); wherein the method (200) comprises
- capturing (201) a measurement signal that is dependent on electromagnetic emission (115) of the electronic module (110), which is emitted during operation of the electronic module (110); wherein the measurement signal exhibits a signal frequency range which differs from an emission frequency range of the electromagnetic emission (115); and
- identifying at least one component (111, 112) of the electronic module (110) based on the measurement signal.

## Amended claims

### Amended claims in accordance with Rule 137(2) EPC.

1. A device (120) for identifying a component (111, 112) of an electronic module (110); wherein the device (120) comprises
- a sensor element (123) which is configured to provide a measurement signal that is dependent on electromagnetic emission (115) of the electronic module (110), which is emitted during operation of the electronic module (110); wherein the measurement signal exhibits a signal frequency range which differs from an emission frequency range of the electromagnetic emission (115); wherein the sensor element (123) comprises a hearing aid coil; and
- a processing unit (121) which is configured to identify at least one component (111, 112) of the electronic module (110) based on the measurement signal.

2. The device (120) of claims 1, wherein
- a maximum frequency of the signal frequency range is lower than a minimum frequency and/or a maximum frequency of the emission frequency range; and/or
- the emission frequency range and the signal frequency range are disjoint from one another.

3. The device (120) of any previous claims, wherein
- a maximum frequency of the signal frequency range is 30 kHz or less; and/or
- a minimum frequency and/or maximum frequency of the emission frequency range is 100kHz or more, notably 1MHz or more.

4. The device (120) of any previous claims, wherein the signal frequency range of the measurement signal comprises and/or corresponds to an audio frequency range.

5. The device (120) of any previous claims, wherein the sensor element (123) is configured to demodulate the electromagnetic emission (115) from the emission frequency range to the signal frequency range, to provide the measurement signal.

6. The device (120) of any previous claims, wherein the processing unit (121) is configured to
- determine a spectrogram of the measurement signal; and
- identify the at least one component (111, 112) of the electronic module (110) based on the spectrogram of the measurement signal.

7. The device (120) of claim 6, wherein the processing unit (121) is configured to
- compare the spectrogram of the measurement signal with a plurality of different reference spectrograms for a corresponding plurality of reference components; and
- identify the at least one component (111, 112) of the electronic module (110), notably to identify the at least one component (111, 112) of the electronic module (110) as being at least one of the plurality of reference components, based on the comparison

8. The device (120) of any of the previous claims, wherein the processing unit (121) is configured to make use of a pattern recognition algorithm, notably an artificial intelligence-based pattern recognition algorithm, to identify the at least one component (111, 112) of the electronic module (110) based on the measurement signal, notably based on a spectrogram of the measurement signal.

9. A method (200) for identifying a component (111, 112) of an electronic module (110); wherein the method (200) comprises
- capturing (201) a measurement signal that is dependent on electromagnetic emission (115) of the electronic module (110), which is emitted during operation of the electronic module (110), using a sensor element (113); wherein the measurement signal exhibits a signal frequency range which differs from an emission frequency range of the electromagnetic emission (115); wherein the sensor element (123) comprises a hearing aid coil; and
- identifying at least one component (111, 112) of the electronic module (110) based on the measurement signal.
